# EUROPÄISCHE PATENTSCHRIFT

(11) **EP 2 027 600 B1**
(45) Veröffentlichungstag und Bekanntmachung des Hinweises auf die Patenterteilung: **11.01.2012**
(21) Anmeldenummer: 07701291.2
(22) Anmeldetag: 01.02.2007
(51) Int. Cl.: H01L 23/538

(54) **Verfahren zum Einbetten zumindest eines Bauelements in einem Leiterplattenelement**
Method for embedding at least one component in a printed circuit board element
Procédé pour noyer au moins un composant dans un élément de carte de circuits imprimés

(30) Priorität: 02.02.2006 AT 1602006
(43) Veröffentlichungstag der Anmeldung: 25.02.2009
(60) Teilanmeldung: 10177700.1
(73) Patentinhaber: AT & S AUSTRIA TECHNOLOGIE & SYSTEMTECHNIK AKTIENGESELLSCHAFT, 8700 Leoben-Hinterberg (AT)
(72) Erfinder: KRIECHBAUM, Arno, A-8700 Leoben (AT); BAUER, Wolfgang, A-8055 Graz (AT); STAHR, Johannes, A-8600 Bruck an der Mur (AT); LIEBFAHRT, Sabine, A-8605 Parschlug (AT)
(74) Vertreter: Sonn & Partner Patentanwälte
(86) Internationale Anmeldenummer: PCT/AT2007/000045
(87) Internationale Veröffentlichungsnummer: WO 2007/087660

(56) Entgegenhaltungen:
- WO-A-2005/015488
- DE-A1- 3 521 528
- DE-A1- 19 954 941
- FR-A1- 2 857 157

## Beschreibung

Die Erfindung betrifft ein Verfahren zum Einbetten zumindest eines elektrischen bzw. elektronischen Bauelements, insbesondere eines Chips (Halbleiterbauelements), in einem Leiterplattenelement, wobei das Bauelement auf einer Unterlage angeklebt wird, wonach über der Unterlage samt Bauelement eine Decklage durch Verpressen angebracht wird, gemäß dem Oberbegriff von Anspruch 1.

Abgesehen von einem äußeren Bestücken von Leiterplatten mit elektrischen bzw. elektronischen Bauelementen, insbesondere aktiven elektronischen Bauelementen bzw. integrierten Schaltungen, die üblicherweise Chips genannt werden, ist es mehr und mehr ein Anliegen der Leiterplattentechnologie, derartige Bauelemente, insbesondere Chips, auch im Inneren des jeweiligen Leiterplattenelements einzubetten, wobei die Bauelemente zwischen einzelnen Lagen des Leiterplattenelements eingeschlossen werden. Eine Technik hiefür ist beispielsweise in der US 6 396 153 B geoffenbart, wobei dort eine Verbindungslage aus isolierendem Material an einer Seite, die später innen zu liegen kommt, mit einem polymeren Kleber beschichtet wird, an dem dann ein Chip angeklebt wird. Danach wird eine Substratlage, beispielsweise durch Spritzgießen oder Verpressen, an der Kleberschicht angebracht und um den Chip herum geformt, so dass schließlich der Chip zwischen diesem Substrat und der Verbindungsschicht, durch die hindurch der Chip kontaktiert wird, eingebettet ist. Eine ähnliche Aufbringung von Chips auf Substraten mittels Klebstoffschicht ist in der DE 4 433 833 A, EP 611 129 A und US 5 564 181 A geoffenbart. Diese Technologie ist aufwendig, wobei auch die flächig aufgebrachte Kleberschicht als zusätzliche Schicht, die auch außerhalb der Chips vorliegt, störend wirkt.

Es ist andererseits bekannt (vgl. z.B. DE 196 42 488 A, DE 35 21 528 A und DE 199 54 941 A), Chips an Leiterplattenelementen durch nur lokal angebrachte Klebstoffbereiche bzw. Klebefolienabschnitte zu befestigen, insbesondere im Zuge eines Einbettens von Chips in Leiterplattenelementen.

Für das Einbetten in Leiterplattenelementen sollen jedoch möglichst dünne Chips verwendet werden, und zwar insbesondere so genannte "gedünnte" Chips, d.h. Chips, deren Substratseite in einem erheblichen Ausmaß abgeschliffen wurde, selbstverständlich ohne die im Chip enthaltene Schaltung zu beeinträchtigen, wobei Chip-Dicken beispielsweise in der Größenordnung von 50µm oder 70µm erreicht werden, wogegen Standard-Chips eine Dicke von z.B. 700µm aufweisen. Derartige gedünnte Chips sind naturgemäß sehr flexibel, so dass sie beim Aufpressen auf lokal in Tröpfchenform aufgebrachten Klebstoffmengen verbogen werden, da diese Klebstoffmengen nicht plan sind, sondern eine bombierte Form aufweisen. Außerdem gelingt es mit den gedünnten Chips nicht, den im Vorhinein auf die Unterlage oder auf die Chip-Unterseite aufgetragenen Klebstoff durch Aufpressen in der gewünschten Weise flächig zu verteilen, so dass abgesehen vom Verbiegen der Chips auch eine ungenügende Klebehaftung die Folge sein kann. Ein weiterer Nachteil ist hier, dass im Fall von verbogenen Chips auch deren nachträgliche Kontaktierung, nach dem Einschließen zwischen Leiterplattenlagen, problematisch ist, da sich die Positionen der Kontaktstellen am Chip durch dessen Verbiegen gegenüber den Soll-Positionen verschoben haben.

Aus der FR 2 857 157 A ist weiters ein Montageverfahren bekannt, bei dem aktive und passive Bauteile vorab auf einem Zwischenträger angebracht werden, bevor sie in einem Kunstharzmaterial eingebettet werden. Der Zwischenträger kann beispielsweise durch eine Klebefolie gebildet sein, und er wird nach dem Anbringen der Bauteile wieder entfernt.

Eine ähnliche Technik ist aus der WO 2005/0154881 A1 bekannt. Auch hier wird ein vorübergehender Träger, insbesondere in Form einer Klebefolie, für Chips verwendet, wobei dieser Zwischenträger nach dem Eingießen der Chips in Kunststoff wieder entfernt wird.

Es ist nun Aufgabe der Erfindung, den Nachteilen des Standes der Technik abzuhelfen und eine Technik vorzuschlagen, mit der Bauelemente, insbesondere auch gedünnte Chips, problemlos beim Einbetten in Leiterplattenelementen an der jeweiligen Unterlage klebend befestigt werden können, wobei die Bauelemente schonend behandelt und hinsichtlich ihrer Position exakt festgelegt werden können. Weiters zielt die Erfindung darauf ab, die Klebebefestigung der Bauelemente in besonders rationeller Weise zu ermöglichen, wobei auch nur lokal ein Klebemittel vorgesehen wird.

Zur Lösung dieser Aufgabe sieht die Erfindung ein Verfahren wie in Anspruch 1 definiert vor. Vorteilhafte Ausführungsformen und Weiterbildungen sind in den Unteransprüchen angegeben.

Beim vorliegenden Verfahren werden somit Klebefolienabschnitte bzw. Klebebandabschnitte eingesetzt, um die Bauelemente auf den jeweiligen Unterlagen durch Ankleben zu befestigen. Diese Abschnitte werden von vorgefertigten, insbesondere bandförmigen, bevorzugt in Rollenform vorliegenden Klebefolien abgetrennt, etwa durch Schneiden oder Stanzen, und sie haben eine vorgegebene einheitliche Dicke, etwa in der Größenordnung von 10µm bis 15µm, wobei sie bevorzugt eine Dicke von ca. 12µm aufweisen. Diese Klebefolien bzw. -bänder sind wärmehärtend, wobei der Kleber nach gesondertem Anbringen des jeweiligen Abschnitts auf der Unterlage vorgehärtet und schließlich, nach Anbringen des Bauelements, vollständig ausgehärtet wird. Die Klebefolienabschnitte werden im Wesentlichen mit den Abmessungen der Bauelemente abgetrennt, z.B. ausgeschnitten bzw. ausgestanzt, und zwar gesondert vor dem Anbringen der Bauelemente auf der Unterlage. Die Klebefolienabschnitte werden in diesem Fall beim Anbringen nach dem Positionieren angepresst und - gegebenenfalls durch Verwendung eines beheizten Positiosier- und Anpress-Werkzeuges - in gewissem Ausmaß vorgehärtet. Eine alternative Möglichkeit besteht darin, dass die Klebefolienabschnitte auf die Unterlage aufgebracht und angepresst werden, wobei die Unterlage von der gegenüberliegenden Seite her erwärmt wird, um so die Klebefolienabschnitte in beschränktem Ausmaß auszuhärten, d.h. vorzuhärten. Vorzugsweise werden auch die Bauelemente erwärmt. Die Vorhärtung hat dabei den Zweck, den Klebefolienabschnitt an der Unterlage ausreichend fest anzuhaften, jedoch soll der Klebefolienabschnitt noch genügend klebrig bleiben, um danach das jeweilige Bauelement durch Anpressen anzuheften.

Die insbesondere bandförmigen Klebefolien können einen an sich üblichen Aufbau haben, wie etwa einen Aufbau mit einer Trägerfolie, die beidseits mit einem Kleber beschichtet ist, wobei über diesen Kleberschichten wiederum Deckfolien angebracht sein können. Eine andere Möglichkeit besteht auch darin, die Trägerfolie wegzulassen und nur eine Kleberschicht z.B. ebenfalls zwischen zwei Deckfolien, vorzusehen. Die Trägerfolie ermöglicht eine Erhöhung der Stabilität, und sie kann beispielsweise aus Polyimid bestehen. Als Deckfolien können beispielsweise Polyethylen-Folien bzw. Polyethylentherephtalat-Folien (PE-Folien bzw. PET-Folien) verwendet werden. Als Kleber wird ein an sich herkömmlicher polymerer Kleber, etwa mit niedrigem Elastizitäts-Modul, bevorzugt in Verbindung mit einem Epoxy-Harz sowie Füllstoffen, verwendet. Auch kann ein modifiziertes Polyimid in Kombination mit Epoxy-Harz eingesetzt werden.

Im Falle der Verwendung von Klebefolienabschnitten mit beidseitigen Deckfolien wird bevorzugt derart vorgegangen, dass die eine, untere Deckfolie, z.B. eine PE-Folie, vor dem Anbringen des Klebefolienabschnitts auf der Unterlage abgezogen wird, um so den Klebefolienabschnitt auf der Unterlage anzukleben, und dass die andere, obere Deckfolie, z.B. eine PET-Folie, erst knapp vor dem Anbringen des Bauelements abgezogen wird, um so bis zu diesem Zeitpunkt die Kleberschicht zu schützen.

Zum vollständigen Aushärten des Klebers des jeweiligen Klebefolienabschnitts wird die Unterlage samt aufgeklebtem Bauelement zweckmäßigerweise in einen Ofen eingebracht und beispielsweise auf eine Temperatur von 130°C bis 150°C oder bis 170°C erwärmt. Dabei kann es auch vorteilhaft sein, diese vollständige Aushärtung des Klebers in einer reaktiven oder inerten Atmosphäre, insbesondere in einer Stickstoff-Atmosphäre, durchzuführen.

Nach dem Ankleben des jeweiligen Bauelements an der Unterlage kann über der Unterlage mit Bauelement durch Verpressen eine Harz-Kupfer-Decklage angebracht werden, wie etwa eine so genannte RCC-Folie (RCC - Resin Coated Copper-Folie - mit Harz beschichtete Kupfer-Folie), und danach können Kontaktlöcher durch Laserbohren in dieser Decklage angebracht werden. Im Anschluss daran erfolgt eine galvanische Metallisierung im Bereich der Kontaktlöcher, um so die eingebetteten Bauelemente oder Leiterschichten zu kontaktieren, wonach schließlich photolithografisch an der äußeren Leiterlage (Kupferlage) eine Strukturierung vorgenommen wird.

Die Erfindung wird nachfolgend anhand von bevorzugten Ausführungsbeispielen, auf die sie jedoch nicht beschränkt sein soll, und unter Bezugnahme auf die Zeichnung noch weiter erläutert. In der Zeichnung zeigen im Einzelnen:
Fig. 1 schematisch einen Querschnitt durch einen Teil eines Multilayer-Leiterplattenelements mit einem eingebetteten Bauelement, z.B. einem gedünnten Chip;
die Fig. 2A bis 2E in schematischen Teil-Querschnitten aufeinander folgende Schritte bei der Herstellung eines solchen Leiterplattenelements unter Einbettung eines Bauelements;
Fig. 3 schematisch in schaubildlichen Darstellungen nebeneinander verschiedene Möglichkeiten zur Anbringung eines Bauelements auf einer Unterlage eines Leiterplattenelements;
Fig. 3A einen schematischen Schnitt durch eine Ausführungsform eines Klebefolienabschnitts;
die Fig. 4A bis 4C eine nicht erfindungsgemäße Möglichkeit zur Anbringung eines breiten bandförmigen Klebefolienmaterials auf einem Chip-Wafer (Fig. 4A) und die Unterteilung des Wafers samt Klebefolie in Chips mit Klebefolienabschnitten (Fig. 4B) sowie die Anbringung der Chips samt daran fixierten Klebefolienabschnitten auf einem Substrat oder einer Unterlage eines Leiterplattenelements (Fig. 4C); und
die Fig. 5A bis 5D eine Ausführungsform des Verfahrens zur Anbringung von Chips (oder allgemein Bauelementen) auf einer Unterlage unter Verwendung von Klebefolienabschnitten, wobei die Abschnitte vorweg von einem Klebeband abgetrennt werden, und zwar entweder mit Hilfe eines Schneidwerkzeuges (Fig. 5A)
oder mit Hilfe eines Stanzwerkzeuges (Fig. 5D), danach gesondert auf der Unterlage angebracht (Fig. 5B) und schließlich die Chips auf diesen Klebefolienabschnitten angeklebt werden (Fig. 5C).

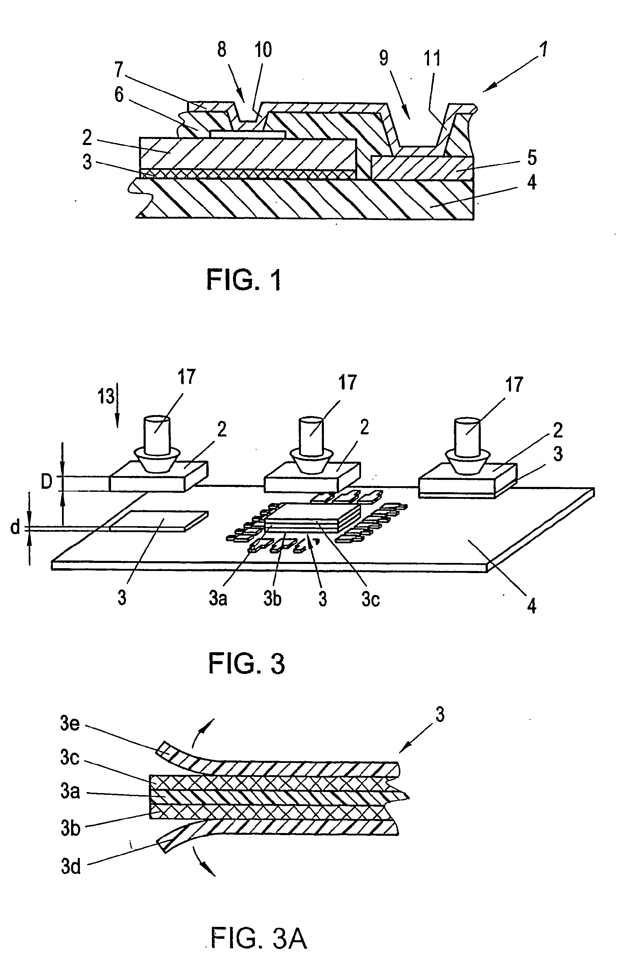

In Fig. 1 ist schematisch ein Teil eines Leiterplattenelements 1 dargestellt, das ein eingebettetes elektrisches Bauelement in Form eines gedünnten Chips 2 enthält. Nachstehend wird der Einfachheit halber beispielhaft immer auf einen solchen Chip 2 Bezug genommen, es ist jedoch im Rahmen der Erfindung vorgesehen, auch andere elektrische bzw. elektronische Bauelemente, insbesondere passive Bauelemente, wie etwa Widerstände, Kondensatoren, ESD (Electro Static Discharge - elektrostatische Entladung)-Schutzelemente, Laserdioden, Fotodioden usw. auf die vorliegende Art und Weise in einem Leiterplattenelement 1 einzubetten. Es handelt sich hierbei um diskrete Bauelemente, wobei bevorzugt die Dicke dieser Bauelemente - entweder von vornherein, durch den Herstellungsvorgang, wie etwa bei Kondensatoren, oder aber durch nachträgliches rückseitiges Dünnen, ca. 50µm bis 70µm beträgt. Derart dünne Bauelemente können beim Einbetten, z.B. zum Schutz vor Feuchtigkeit oder mechanischer Beanspruchung, vom Harz sicher umschlossen werden, wobei dann eine entsprechende Dielektrikumsdicke über dem Bauelement vorhanden ist und eine ebene Oberfläche erzielt wird. Dies ist einerseits für Laser-Bohrprozesse wichtig, aber auch für andere Prozesse, die eine plane Oberfläche benötigen.

Das Bauelement bzw. der Chip 2 ist mit Hilfe eines Abschnitts 3 einer bandförmigen Klebefolie, nachstehend Klebefolienabschnitt 3 genannt, auf einer Unterlage 4, beispielsweise einem üblichen FR4-Basismaterial (Harzkern, insbesondere mit Leiterlage) oder Substrat, wie es in der Leiterplattentechnologie in herkömmlicher Weise verwendet wird, angeklebt. Das Leiterplattenelement 1 kann demgemäß auf der Unterlage 4 in an sich üblicher Weise einen Leiterzug 5 z.B. in Form einer strukturierten Cu-Lage, aufweisen, der zu nicht näher veranschaulichten weiteren elektrischen Bauelementen im Leiterplattenelement 1 führt; über diesem Leiterzug 5 sowie über dem Chip 2 ist eine Decklage 6 aus Harz mit einer oberen Kupferbeschichtung 7 angebracht, wobei es sich hier beispielsweise um eine übliche RCC-Folie (Resin Coated Copper-Folie, also ein Harz-Kupfer-Folienlaminat) handeln kann. In dieser Decklage 6 sind weiters zur Kontaktierung des Chips 2 sowie des Leiterzuges 5 Laser-Bohrungen bzw. Mikro-Vias 8, 9 vorgesehen, die an den Seitenwänden eine galvanische Metallisierung 10 bzw. 11 aufweisen.

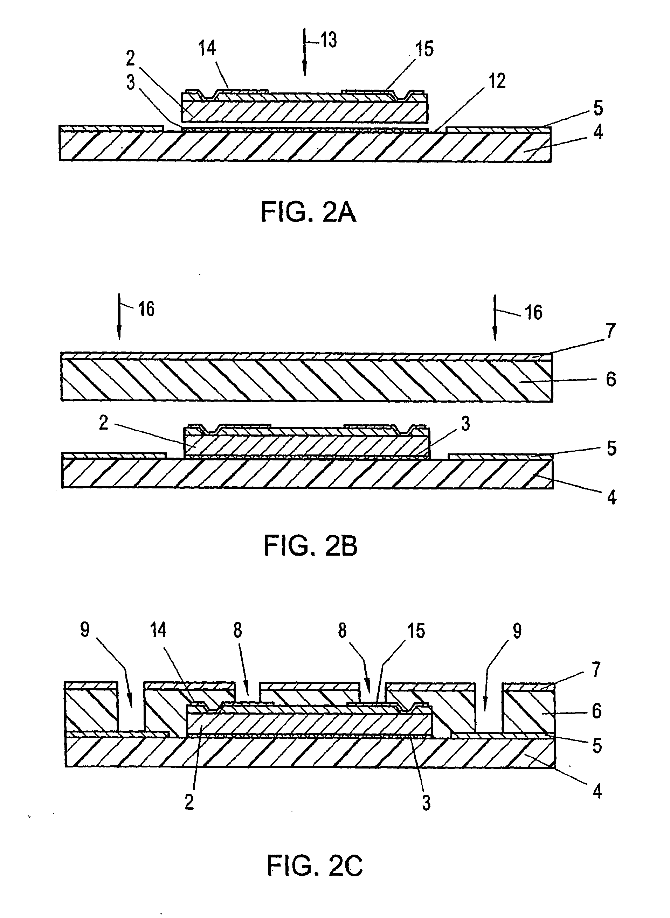

In Fig. 2A ist im Einzelnen die Anbringung eines Bauelements bzw. eines Chips 2 auf einer derartigen Unterlage 4 gezeigt. Wie dabei ersichtlich ist, wird auf der Unterlage 4, d.h. am Leiterplattenkern, in einem Bereich 12 vorab eine Freistellung in der leitenden Beschichtung, d.h. im Leiterzug 5, vorgesehen, und in diesem Bereich 12 wurde bereits ein Klebebandabschnitt 3 positioniert und unter Anpressen angeklebt sowie in einem vorgegebenen Ausmaß auch vorgehärtet, damit seine Haftung auf der Unterlage 4 sichergestellt ist. Auf diesem Klebebandabschnitt 3 wird nun der Chip 2 durch Aufdrücken, wie mit dem Pfeil 13 dargestellt, angebracht und angeklebt. Der angeklebte Zustand des Chips 2 ist im unteren Teil der Fig. 2B ersichtlich. Der Chip 2 hat weiters an seiner Oberseite Kontaktbereiche 14, 15, die später über die bereits anhand der Fig. 1 erwähnten Laserbohrungen 8 durch die Decklage 6 hindurch kontaktiert werden.

Nach Anbringen des jeweiligen Chips 2 auf der Unterlage 4 erfolgt ein vollständiges Aushärten des Klebematerials des Klebebandabschnittes 3, was in einem Ofen in einer Stickstoff-Atmosphäre bei einer Temperatur von beispielsweise 130°C bis 150°C oder aber auch von 150°C bis 170°C, je nach Art der verwendeten Materialien, erfolgen kann.

Mit Hilfe der Klebebandabschnitte 3 ist eine genaue, sichere Aufbringung und Klebebefestigung der Chips 2 möglich, auch wenn es sich bei diesen Chips 2 um so genannte gedünnte Chips handelt, die wie erwähnt durch Abschleifen eines wesentlichen Teiles des Chips-Substrats eine Dicke von z.B. bloß ca. 50µm, allgemeiner 10µm bis 70µm (statt z.B. ca. 700µm), aufweisen können, und die daher sehr biegsam und empfindlich sind. Die herkömmliche Aufbringung eines flüssigen Klebers in Tropfenform wäre für derartige gedünnte Chips problematisch, da mit den gedünnten Chips die Klebertropfen nicht plan verteilt werden können, wenn sie auf diese aufgepresst werden, abgesehen davon, dass außerordentlich geringe Klebermengen notwendig wären, so dass die Dosierung schwierig und so bei diesem Standardverfahren keine genaue und zuverlässige Klebebefestigung der Chips an der Unterlage 4 möglich wäre. Demgegenüber kann mit Hilfe der beschriebenen Klebebefestigung durch Verwendung von Klebebandabschnitten 3 eine exakte Aufbringung und eine gute Haftung der Chips 2, im Rahmen der geforderten mechanischen Eigenschaften, ermöglicht werden.

Nach dem Anbringen des Klebebandabschnitts 3 auf der Leiterplatten-Unterlage 4 und des Chips 2 auf den Klebebandabschnitt 3 wird wie erwähnt die Unterlage 4, bevorzugt auf einem Paneel mit einer Vielzahl von ähnlich bestückten Leiterplatten-Unterlagen, in einen Ofen gebracht, um den Klebstoff vollständig auszuhärten. Dies kann in einer reaktiven oder aber inerten Atmosphäre, z.B. Stickstoff, geschehen.

Im Anschluss daran wird im Zuge eines herkömmlichen Verpressens mit einer RCC-Folie 6, die eine obere Kupferschicht 7 aufweist, und die beispielsweise aus einem Epoxy-Harz besteht, unter Anwendung von Temperatur und Druck (s. die Pfeile 16 in Fig. 2B) die Einbettung des Chips 2 im Inneren des vorläufigen Leiterplattenelements bewerkstelligt. Die Temperatur kann dabei, wieder je nach verwendeten Materialien, 200°C oder 220°C betragen, und der Druck beim Verpressen beträgt beispielsweise 20bar oder 30bar.

Im so hergestellten Multilayer-Leiterplattenelement werden dann mit Hilfe von Laserstrahlen die Bohrungen 8, 9 zur Kontaktierung der innen liegenden Bauelemente, insbesondere Chips 2, sowie Leiterzüge 5 angefertigt; das Ergebnis dieses Verfahrensschrittes ist in Fig. 2C gezeigt.

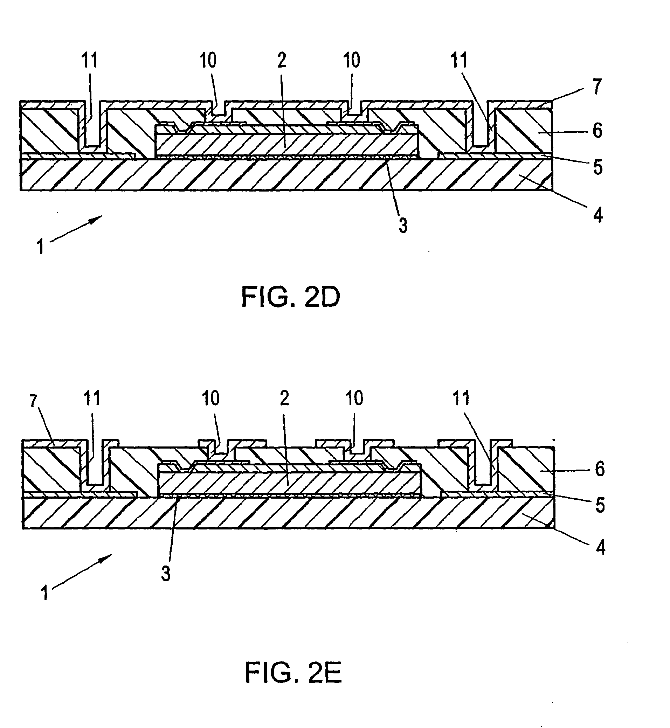

Im Anschluss daran erfolgt, wie in Fig. 2D gezeigt, eine Ankontaktierung der Kontaktstellen 14, 15 der Bauelemente 2 sowie der Leiterzüge 5 im Inneren des Multilayers durch galvanisches Metallisieren, wobei die Wände der Bohrungen 8, 9 mit Kupfer belegt werden, so dass die Metallisierungen 10, 11 erhalten werden. Danach wird mit Hilfe eines herkömmlichen photolithografischen Prozesses die obere Kupferschicht 7 strukturiert, so dass schließlich das Leiterplattenelement 1, wie in Fig. 2E dargestellt, erhalten wird.

In Fig. 3 sind schematisch und der Einfachheit halber nebeneinander im Zusammenhang mit einem einzelnen Substratkern als Unterlage 4 drei verschiedene Möglichkeiten für eine Bauelement-Befestigung mit Hilfe von Klebefolienabschnitten 3 angedeutet.

Im Einzelnen ist dabei auf der linken Seite dargestellt, dass ein Klebefolienabschnitt 3, der nur aus Klebematerial besteht, wobei etwaige untere und obere Deckfolien bereits abgezogen wurden, im Vorhinein auf der Unterlage 4 positioniert, angepresst und vorgehärtet wurde. Danach wird mit Hilfe eines temperierten Stempel-Saug-Werkzeuges 17 ein Bauelement 2, das mit Hilfe von Vakuum am Werkzeug 17 festgehalten wird, computergesteuert in Position gebracht und entsprechend dem Pfeil 13 (vgl. auch Fig. 2A) auf den Klebefolienabschnitt 3 aufgepresst. Wie erwähnt kann das dünne bzw. gedünnte Bauelement 2 beispielsweise eine Dicke in der Größenordnung von bloß ca. 50µm aufweisen, vgl. das Maß D in Fig. 3, und der Klebefolienabschnitt 3 kann beispielsweise eine Dicke d in der Größenordnung von nur 8µm bis 15µm besitzen.

Im mittleren Teil der Fig. 3 ist eine vergleichbare Anbringung eines gedünnten bzw. dünnen Bauelements 2 mit Hilfe eines Werkzeuges 17 veranschaulicht, jedoch ist hier ein Klebefolienabschnitt 3 gezeigt, der eine Trägerfolie 3a zwischen zwei Kleberschichten 3b, 3c aufweist, vgl. im Übrigen auch Fig. 3A. Überdies kann im ursprünglichen Zustand dieser Klebefolienabschnitt 3 eine untere Deckfolie 3d und eine obere Deckfolie 3e aufweisen, wie in Fig. 3A veranschaulicht ist, wobei diese Deckfolien 3d, 3e beim Anbringen des Klebefolienabschnittes 3 bzw. des Bauelements 2 abgezogen werden, wie dies schematisch in Fig. 3A angedeutet ist. Im Einzelnen wird dabei selbstverständlich als erstes die untere Decklage 3d abgezogen, wonach der Klebefolienabschnitt 3 auf die Leiterplatten-Unterlage 4 aufgedrückt wird. Die obere Deckfolie 3e wird bevorzugt erst unmittelbar vor Anbringen des Bauelements 2 abgezogen, um so die obere Kleberschicht 3c möglichst lange zu schützen.

Ganz allgemein kann im Fall eines Klebefolienmaterials mit einfacher Kleberschicht (s. Fig. 3, links), d.h. ohne Trägerfolie, eine Dicke zwischen beispielsweise 10µm und 50µm (ohne Deckfolien) gegeben sein, während ein Klebefolienabschnitt mit Kleberschichten 3b, 3c beidseits einer Trägerfolie 3a durchaus etwas dicker, etwa 12µm bis 200µm dick, sein kann. Die obere Deckfolie kann beispielsweise aus PET bestehen und eine Dicke von 50µm aufweisen, wogegen die untere, als erstes abzuziehende Deckfolie aus PE-Material bestehen und eine Dicke von 25µm aufweisen kann.

Als Klebematerial eignet sich eine polymere Adhesiv-Kombination, die auch Epoxy-Harz enthalten kann, und die beispielsweise auf Basis eines modifizierten Polyimids oder eines Polymers mit niedrigem Elastizitäts-Modul hergestellt sein kann.

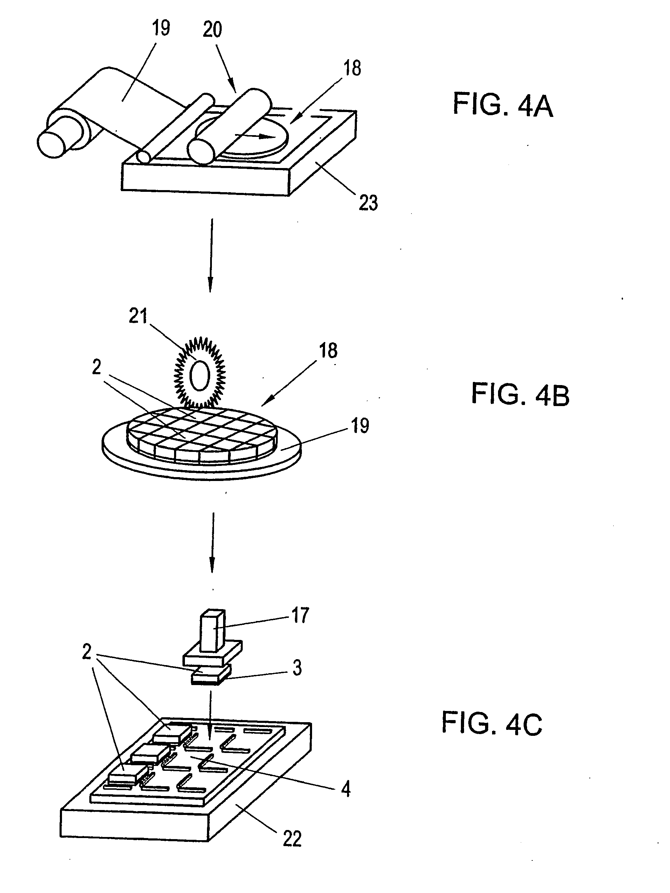

In Fig. 3 ist schließlich auf der rechten Seite der Darstellung noch eine weitere, nicht erfindungsgemäße Möglichkeit zur Bauelement-Befestigung gezeigt, wobei der Klebefolienabschnitt 3 vorweg als erstes an der Unterseite des jeweiligen Bauelements 2 angebracht und das Bauelement 2 samt Klebefolienabschnitt 3 mit Hilfe des Werkzeugs 17 in der gewünschten Position auf der Unterlage 4 angebracht und festgeklebt wird. Eine derartige vorherige Anbringung von Klebefolienabschnitten 3 an den Bauelementen 2 ergibt sich beispielsweise dann, wenn wie in den Fig. 4A, 4B und 4C gezeigt ein entsprechend breites Klebeband, d.h. bandförmiges Klebefolienmaterial 19, an der Unterseite eines eine Vielzahl von Chips 2 oder dgl. Bauelementen enthaltenden Wafers 18 angebracht wird. In Fig. 4A ist schematisch bei 20 auch angedeutet, wie das Klebefolienmaterial 19 nach Abziehen einer etwaigen unteren PE-Deckfolie auf den Wafer 18 mit Hilfe einer Rolle auflaminiert wird. Die obere PET-Deckfolie, die bei der Anbringung gemäß der Darstellung in Fig. 3 auf der rechten Seite dann an der Unterseite zu liegen kommt, kann ebenfalls sofort oder aber erst unmittelbar vor Anbringung der Chips 2 auf der Leiterplatten-Unterlage 4 abgezogen werden. Nach diesem Laminieren der Wafer-Rückseite mit Klebefolienmaterial 19, wie in Fig. 4A dargestellt, erfolgt gemäß Fig. 4B ein Unterteilen des Wafers 18 in die einzelnen Chips 2, was ganz schematisch mit Hilfe eines Schneidwerkzeuges 21 angedeutet ist.

Im Anschluss daran werden die Chips 2 mit den so direkt an der Unterseite der Chips 2 erhaltenen Klebefolienabschnitten 3 auf der Leiterplatten-Unterlage 4 angebracht, wozu das bereits anhand der Fig. 3 erläuterte temperierte Saug-Werkzeug 17 verwendet werden kann.

Dabei kann die Unterlage 4 von der Unterseite her mit Hilfe eines Heizblocks 22 erwärmt werden, ebenso wie beim Aufbringen des Klebefolienmaterials 19 auf den Wafer 18 gemäß Fig. 4A ein beheizter Block 23, der beispielsweise bei einer Temperatur von ca. 80°C gehalten wird, eingesetzt werden kann, um so jeweils das Klebstoffmaterial bereits teilweise auszuhärten.

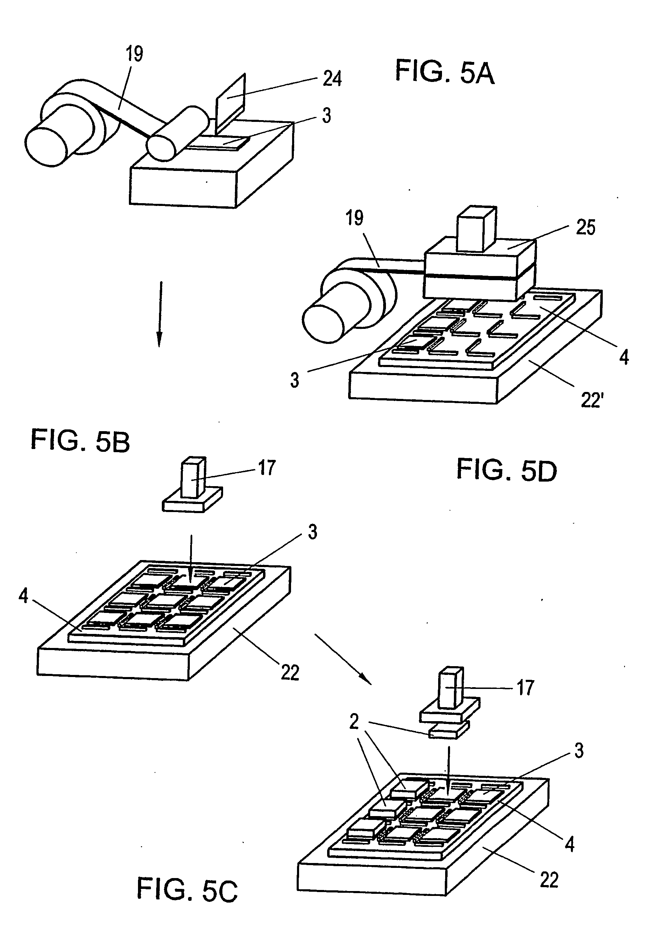

In den Fig. 5A bis 5D ist alternativ zur Fig. 4A bis 4C eine Technik veranschaulicht, bei der vorweg die einzelnen Klebefolienabschnitte 3 beispielsweise mit Hilfe eines Schneidwerkzeuges 24 durch Querschneiden von einem bandförmigen Klebefolienmaterial 19 abgetrennt werden. Dabei wird vorweg die eine Deckfolie, nämlich die PE-Deckfolie, abgezogen, und danach werden die einzelnen Klebefolienabschnitte 3 geschnitten sowie mit Hilfe des Werkzeuges 17 auf der Leiterplatten-Unterlage 4 aufgebracht, vgl. Fig. 5B, wobei die Leiterplatten-Unterlage 4 wiederum auf einem beheizten Block 22 aufliegen kann, um so das Klebematerial der Klebefolienabschnitte 3 bereits vorläufig in einem gewissen Ausmaß auszuhärten.

Als Alternative dazu kann gemäß Fig. 5D ein Stanzwerkzeug 25 zum Ausstanzen und unmittelbaren Aufpressen der Klebefolienabschnitte 3 auf die Unterlage 4 verwendet werden. Die Unterlage 4 kann dabei auf einem modifizierten Heizblock 22' aufliegen, der beispielsweise auf einer Temperatur von 140°C gehalten wird.

Im Anschluss daran werden, wie immer auch die Klebefolienabschnitte 3 auf der Unterlage 4 angebracht wurden, die Bauelemente 2 auf den Klebefolienabschnitten 3 auf der Unterlage 4 mit Hilfe des Werkzeuges 17 angebracht. Dabei wird zuvor, wie oben erwähnt, eine etwaige obere PET-Deckfolie von den Klebefolienabschnitten 3 abgezogen.

Das Klebefolienmaterial 19 kann wie in Fig. 4A oder 5A bzw. 5D gezeigt als Rollenmaterial vorliegen und von der Rolle abgezogen werden, um die einzelnen Klebefolienabschnitte 3 zu erhalten.

Vor dem Anbringen der Klebefolienabschnitte 3 auf der Unterlage 4 kann diese Unterlage 4 auch mit einer Infrarotlampe in den Befestigungspositionen bestrahlt und vorerwärmt werden, wobei die Heizdauer je nach Leistung der Infrarotlampe 10 bis 20 Sekunden betragen kann. Die beim Aufdrücken der Klebefolienabschnitte 3 bzw. der Bauelemente 2 aufgebrachte Kraft betrug bei Tests 37N. Die Aushärttemperatur für den Klebstoff der Klebefolienabschnitte 3 betrug 150°C bzw. 170°C.

## Patentansprüche

1. Verfahren zum Einbetten zumindest eines elektrischen bzw. elektronischen Bauelements (2), insbesondere eines Chips, in einem Leiterplattenelement (1), wobei das Bauelement (2) auf einer Unterlage (4) angeklebt wird, wonach über der Unterlage (4) samt Bauelement (2) eine Decklage (6) durch Verpressen angebracht wird, **dadurch gekennzeichnet, dass** das Bauelement (2) auf der Unterlage (4) mit Hilfe eines thermohärtenden Klebefolienabschnitts (3) angeklebt wird, der vor dem Anbringen des Bauelements (2) gesondert auf der Unterlage (4) angebracht und beim Anbringen angepresst und vorgehärtet wird, wobei der Klebefolienabschnitt (3) mit Hilfe eines Positionier- und Anpress-Werkzeugs (17) positioniert und angepresst sowie vorgehärtet wird, indem das Positionier- und Anpress-Werkzeug (17) erwärmt wird, oder wobei der Klebefolienabschnitt (3) nach dem Positionieren auf der Unterlage (4) gegen diese angepresst und die Unterlage (4) von der anderen Seite her erwärmt wird.

2. Verfahren nach Anspruch 1, **dadurch gekennzeichnet, dass** zusätzlich das Bauelement erwärmt wird.

3. Verfahren nach Anspruch 1 oder 2, **dadurch gekennzeichnet, dass** ein Klebefolienabschnitt (3) mit beidseitigen Deckfolien (3d, 3e) verwendet und vor dem Anbringen auf der Unterlage (4) die eine, untere Deckfolie (3d) abgezogen wird, wogegen die andere, obere Deckfolie (3e) erst nach dem Anbringen des Klebefolienabschnitts (3) und vor dem Anbringen des Bauelements (2) abgezogen wird.

4. Verfahren nach einem der Ansprüche 1 bis 3, **dadurch gekennzeichnet, dass** eine bandförmige Klebefolie (19) eingesetzt wird, von der die einzelnen Klebefolienabschnitte (3), z.B. durch Schneiden oder Stanzen, abgetrennt werden.

5. Verfahren nach einem der Ansprüche 1 bis 4, **dadurch gekennzeichnet, dass** die Unterlage (4) samt aufgeklebtem Bauelement (2) zur vollständigen Aushärtung des Klebers des Klebefolienabschnitts (3) erwärmt wird.

## Claims

1. A method for embedding at least one electric or electronic component (2), in particular a chip, in a printed circuit board element (1), wherein the component (2) is adhered to a base (4), whereupon a cover layer (6) is applied on the base (4) and component (2) by pressing, **characterised in that** the component (2) is adhered to the base (4) by means of a thermosetting adhesive film section (3) which is separately applied to the base (4) prior to application of the component (2) and is pressed and pre-cured during its attachment, wherein the adhesive film section (3) is positioned and pressed on as well as pre-cured by means of a positioning and pressing tool (17) by heating the positioning and pressing tool (17), or wherein the adhesive film section (3), after having been positioned on the base (4), is pressed thereto and the base (4) is heated from the other side.

2. The method according to claim 1, **characterised in that** the component is additionally heated.

3. The method according to claim 1 or 2, **characterised in that** an adhesive film section (3) with cover films (3d, 3e) provided on both sides is used, and before application on the base (4), the one, lower cover film (3d) is pulled off, whereas the other, upper cover film (3e) is pulled off only after the attachment of the adhesive film section (3) and prior to the attachment of the component (2).

4. The method according to any one of claims 1 to 3, **characterised in that** a strip-shaped adhesive film (19) is used from which the individual adhesive film sections (3) are separated, e.g. by cutting or by punching.

5. The method according to any one of claims 1 to 4, **characterised in that** the base (4) together with the component (2) glued thereto is heated for a complete curing of the adhesive of the adhesive film section (3).

## Revendications

1. Procédé pour noyer au moins un composant électrique ou électronique (2), en particulier une puce, dans un élément de carte de circuits imprimés (1), dans lequel le composant (2) est collé sur un support (4), ensuite une couche extérieure (6) est déposée par pressage sur le support (4) en plus du composant (2), **caractérisé en ce que** le composant (2) est collé sur le support à l'aide d'une section de feuille adhésive thermodurcissable (3), qui est déposée avant la mise en place du composant (2) séparément sur le support (4) et est pressée lors du dépôt et pré-durcie, dans lequel la section de feuille adhésive (3) est positionnée et pressée ainsi que pré-durcie à l'aide d'un outil de positionnement et de pressage (17), où l'outil de positionnement et de pressage (17) est chauffé, ou dans lequel la section de feuille adhésive (3) est pressée après positionnement sur le support (4) contre celui-ci et le support (4) est chauffé depuis l'autre côté.

2. Procédé selon la revendication 1, **caractérisé en ce que**, de plus, le composant est chauffé.

3. Procédé selon la revendication 1 ou 2, **caractérisé en ce qu'**une section de feuille adhésive (3) est utilisée avec des feuilles de recouvrement bilatérales (3d, 3e) et la feuille de recouvrement inférieure (3d) est retirée avant la mise en place sur le support (4), contrairement à la feuille de recouvrement supérieure (3e) qui n'est retirée qu'après la mise en place de la section de feuille adhésive (3) et avant la mise en place du composant (2).

4. Procédé selon l'une des revendications 1 à 3, **caractérisé en ce qu'**une feuille adhésive en forme de bande (19) est insérée, dont les différentes sections de feuille adhésive (3) sont séparées par exemple par découpage ou estampage.

5. Procédé selon l'une des revendications 1 à 4, **caractérisé en ce que** le support (4) y compris le composant collé (2) est chauffé jusqu'à durcissement complet de l'adhésif de la section de feuille adhésive (3).
